# EUROPEAN PATENT SPECIFICATION

(11) **EP 0 890 186 B1**
(45) Date of publication and mention of the grant of the patent: **04.01.2006**
(21) Application number: 97915822.7
(22) Date of filing: 26.03.1997
(51) Int. Cl.: H01L 21/20, H01L 21/265, H01L 29/24

(54) **A METHOD FOR PRODUCING A SEMICONDUCTOR DEVICE HAVING SEMICONDUCTOR LAYERS OF SiC BY THE USE OF AN IMPLANTING STEP**
VERFAHREN ZUR HERSTELLUNG EINES HALBLEITERBAUELEMENTS MIT SiC-HALBLEITERSCHICHTEN MITTELS EINES IMPLANTIERUNGSSCHRITTS
PROCEDE DE FABRICATION D'UN DISPOSITIF A SEMI-CONDUCTEUR POSSEDANT DES COUCHES SEMI-CONDUCTRICES EN SiC AU MOYEN D'UNE ETAPE D'IMPLANTATION

(30) Priority: 27.03.1996 SE 9601176
(43) Date of publication of application: 13.01.1999
(73) Proprietor: CREE, INC., Durham, NC 27703 (US)
(72) Inventor: SCHÖNER, Adolf, S-164 44 Kista (SE); ROTTNER, Kurt, S-164 43 Kista (SE); NORDELL, Nils, S-164 41 Kista (SE)
(74) Representative: Olsson, Jan
(86) International application number: PCT/SE1997/000532
(87) International publication number: WO 1997/036317

(56) References cited:
- EP-A- 0 627 761
- US-A- 5 135 885
- US-A- 5 296 727
- US-A- 5 318 915
- US-A- 5 322 802

## Description

### TECHNICAL FIELD OF THE INVENTION AND PRIOR ART

The present invention relates to a method of producing a semiconductor device having semiconductor layers of SiC with at least three doped layers on top of each other, comprising a step a) of growing a first semiconductor layer of SiC, a step b) following upon step a) of implanting an impurity dopant into said first layer for forming a second doped surface layer as a sub-layer therein.

Such a method is disclosed in US-A-5 135 885.

Such an ion implantation technique may be used for production of all types of semiconductor devices, such as for example different types of diodes, transistors and thyristors, and it is an attractive technique in device fabrication as it allows control of both impurity level and distribution. This technique is well devoped for Si-devices, but the method successfully used for ion implantation for such devices may not be utilised for SiC-devices due to the completely different character of SiC with respect to Si. Such devices of SiC are particularly used in applications in which it is possible to benefit from the superior properties of SiC in comparison with primarily Si, namely the capability of SiC to function well under extreme conditions. SiC has a high thermal stability due to a large bandgap energy, such that devices fabricated from said material are able to operate at high temperatures, namely up to 1000 K.

Furthermore, it has a high thermal conductivity and a more than five times higher breakdown field than Si, so that SiC-devices may be arranged at a high density. Therefore SiC is well suited as a material in high power devices operating under conditions where high voltages may occur in the blocking state of the device.

Accordingly, it is highly desired to find means to control this technique of device fabrication also for SiC for allowing the production of an extended amount of SiC-semiconductor devices of a high quality especially for power applications.

Known methods of the type defined in the introduction, i.e. which use an implantation step, have several limitations. One principle limitation of ion implantation is that the doping concentration can only be enlarged, which means that the density of impurity centres can only be increased by implantation. However, in some device applications structures with low doped layers on top of higher doped layers are desirable, but it has not been succeeded so far to utilise the implantation technique in SiC and the advantages thereof connected to the possible formation of planar structures instead of mesa-structures for obtaining such desired structures with a high quality. First of all, the depth into which it may be implanted in SiC is strongly limited. This maximum implantation depth is given by the acceleration energy of the ions shot on the SiC-surface. Furthermore, the minimum thickness of such a layer increases with said acceleration energy, due to range straggling, which means that the limit of a layer created by implantation while using a high acceleration energy will be very broad, and the minimum thickness of the layer might be too large for some device applications. Additionally, the damage profile of a high energy implantation extends up to the surface of the SiC-layer into which it has been implanted. Thus, in the low doped surface layer the implantation damage can act as life time killer for charge carriers and decrease the carrier mobility severely by formation of compensation. Accordingly, it has not been possible to form a layer having a thick layer on top thereof in SiC by using the implantation technique for forming the lower layer, and the formation of a layer by implantation in SiC at a distance from the surface thereof has resulted in a very poor quality of the layer on top of the implanted layer.

### SUMMERY OF THE INVENTION

The object of the present invention is to provide a method of the type mentioned in the introduction making it possible to solve the problems mentioned above to a large extent.

This method contains a step c) following upon step b) and in which a third semiconductor layer of SiC is epitaxially grown on top of said second layer of SiC. The combination of ion implantation and epitaxial growth thereafter, which in the fact is a so called regrowth, since the first layer is first grown and a further process step is then carried out before the epitaxial growth of the third layer takes place, is very advantageous, since it is less complicated to carry out such a regrowth on an implanted structure than on etched mesa-structures having different crystal orientation around t.he mesa. Furthermore, the surface used for the regrowth can be chosen in a way to give optimum results of the regrowth, for instance by determining the surface orientation of said second layer already by the epitaxial growth of the first layer, since the ion implantation does not change this condition. It would also be possible to obtain this orientation by for instance hydrogen-etching. Another advantage of such a method is that it will be possible to position a certain layer obtained by implantation deep into a semiconductor structure without damaging the layer on top thereof, since the implantation damage is restricted to the implanted volume and does not affect other device parts. Thus, it will be possible to form a low doped layer on top of the implanted layer without any damages therein being harmful to the carrier life time and mobility in the low doped layer. Of course the layer on top of the implanted layer does not have to be low doped, but it may be given any doping concentration desired. Accordingly, the depth of buried structures is no longer limited by the implantation energy, so that it will be possible to use a lower energy for said implantation and by that obtain a more clear border between the layer implanted and the other layers. Thus, the combination of implantation and regrowth allows the fabrication of designed buried structures in SiC while obtaining a high quality of all the layers of the semiconductor device so created.

The growth in said step c) is carried out at such a high temperature that the dopants implanted in step b) are made electrically active and implantation damages are reduced. Accordingly, the epitaxial growth of said third layer will in this way replace the annealing step normally required for activating the dopant implanted. It would, however, still be possible to include an additional annealing step in the re-growth procedure.

According to a preferred embodiment of the invention said third semiconductor layer is in step c) grown by Chemical Vapour Deposition, which is the most frequently used technique for epitaxially growing layers of SiC and makes it possible to obtain a high quality of such layers grown. Such CVD-growth is carried out at such high temperatures that the implanted second layer will be automatically annealed during this growth.

The implantation in step b) is carried out for producing a second doped surface layer, which is surrounded, except for the top surface thereof, by said first semiconductor layer, and said third semiconductor layer is in step c) epitaxially grown on top of said second layer as well as regions of said first layer next thereto and surrounding and totally burying said second semiconductor layer. This constitutes an advantageous way to form a buried structure, i.e. a structure in which a layer is totally surrounded by other layers and accordingly the junctions to this layer are in the bulk of a semiconductor device with this structure.

According to another preferred embodiment of the invention an impurity dopant of a first conductive type, one of a) n b) p, is in step b) implanted in said first semiconductor layer being doped according to a second opposite conductivity type for forming a pn-junction at the interface between said first and second layers. This makes it possible to use the implantation technique for forming pn-junctions in a semiconductor device also when this has been located under another semiconductor layer and accordingly said second layer is buried in the semiconductor structure.

According to another preferred embodiment of the invention boron is implanted as impurity dopant in step b) and the implantation is carried out while keeping the first semiconductor layer of SiC at a temperature of 400-600°C. Experiments have shown that the regrowth of SiC on the layer so obtained leads to good results.

According to another preferred embodiment of the invention said third semiconductor layer is in step c) grown with a lower doping concentration than the doping concentration of the second semiconductor layer obtained by said implantation. In this way it will be possible to form a low doped layer of a high quality on the top of a layer obtained by ion implantation, and according to another preferred embodiment of the invention said third semiconductor layer is in step c) grown while giving it a low doping concentration. This means that the doping concentration will be below 10¹⁷cm⁻³, and the doping may be obtained without any supply of dopants during said growth but through only the inevitable impurity incorporation of nitrogen during the growth process. Although this constitutes preferrred embodiments of the invention other doping concentrations are of course conceivable.

According to another preferred embodiment of the invention said method comprises several alternating successive steps of implantation and regrowth according to steps b) and c). Such a method enables the fabrication of semiconductor structures having an arbitrary number of implanted buried layers at any desired depth therein.

According to a further preferred embodiment of the invention the regrowth of layers is co-ordinated with the conditions of the implantation step following thereupon for making the layer obtained by that implantation step extending through the entire layer previously regrown and connecting to the layer previously obtained by the previous implantation step for forming a continuous thick implanted layer. Accordingly, such a series of successive regrowth and implantation steps may be used for forming also thick layers of a high quality by using the implantation technique, so that much thicker layers may be obtained by implantation than before.

According to another preferred embodiment of the invention a regrowth step is carried out after the last implantation step for forming said thick continuous implanted layer for forming a semiconductor device having a thick buried layer.

This method enables the formation of a thick buried semiconductor layer in SiC by using the implantation technique.

Further preferred features and advantages of the invention will appear from the following description and the other dependent claims.

### BRIEF DESCRIPTION OF THE DRAWING

With reference to the appended drawing below, follows a specific description of preferred embodiments of the invention cited as examples.

In the drawings:
- Fig. 1: illustrates symmetrically the semiconductor structure produced by a method according to the prior art and a graph of the implantation damage thereof as a function of the depth of the semiconductor layer,
- Fig. 2: is a view corresponding to Fig. 1 of a semiconductor structure produced by a method according to a preferred embodiment of the invention and a graph of the implantation damage thereof as a function of the depth of the semiconductor layer,
- Fig. 3A-F: are very schematic views illustrating how a thick buried semiconductor layer produced by implantation may be created by alternating successive im- plantation and regrowth steps in a method according to a preferred embodiment of the invention, and
- Fig. 4: is a schematic view illustrating a device structure in the form of a high voltage J-FET obtainable by utilising the method according to the present invention.

### DETAILED DESCRIPTION OF PREFERRED EMBODIMENTS OF THE INVENTION

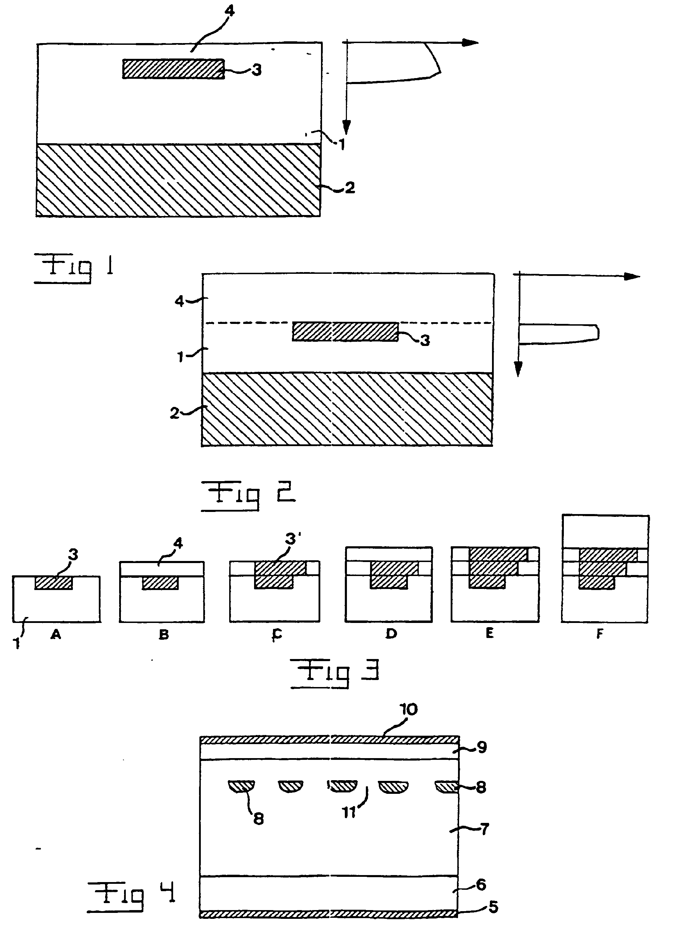

Fig. 1 illustrates clearly the disadvantages of prior art methods for producing at least three successive semiconductor layers of SiC on top of each other by using the implantation technique for creating the intermediate layer. In this method a first low doped n-type layer 1 of SiC is epitaxially grown on top of a highly doped n-type substrate layer 2, through which a good ohmic contact may be established to a device. After that impurity dopants of p-type have been implanted into the first layer 1 by using a high acceleration energy, so that a second doped layer 3 of p-type is created in said first layer 1. After that the layers have to be heated at a high temperature for annealing the second layer 3. In the vertical direction across the second layer 3 the following order of layers are in this way created: A first layer 1 under the second layer 3 and on top thereof a third layer 4 constituted by the low doped n-type region of said first layer 1 located over said second layer. The graph to the right illustrating the implantation damage as a function of the depth shows that this third layer 4 is severely damaged. The damage acts as life time killer and decreases the carrier mobility dramatically by formation of compensation.

Fig. 2 illustrates a semiconductor structure produced by a method according to the invention. In this method a step a) of epitaxial growth of a first semiconductor layer 1 of SiC on top of the substrate layer 2 has first been carried out. After that ions of p-type have been implanted by using a comparatively low energy for forming a second surface layer 3 in said first layer 1. The second layer 3 may be given rather distinct borders thanks to the possibility to implant the ions with a comparatively low energy. After that a third step c) is carried out, and in which a third layer 4 of SiC is epitaxially grown on top of the first 1 and second 3 layer while using the Chemical Vapour Deposition technique, which means that the layers are during this growth heated at a high temperature, preferably above 1500°C, which will turn the impurity dopants implanted in step b) electrically active and reduce implantation damages. This regrowth may result in a very high quality of said third layer, since the ion implantation has not changed the orientation of the layer thereunder and the surface on which it is grown has the desired quality. It is clearly illustrated that a buried layer 3, which preferably has another doping than the first 1 and third 4 layers may be buried in this way in an arbitrary depth without using any high implantation energies. Furthermore the graph to the right shows that the implantation damage is restricted to the implanted volume and does not affect other device parts.

It is illustrated in Fig. 3 how it will be possible to form thicker buried structures by successive regrowth and implantation steps. Fig. 3A illustrates how an implanted layer 3 is created in a first layer 1. Fig. 3B shows that a third layer 4 has been epitaxially grown on top of the first 1 and second 3 layers to a thickness substantially corresponding to said second layer and while annealing that layer. Fig 3C illustrates how a further implantation step is carried out for forming another implanted layer 3', whereupon according to Fig. 3D a further regrowth step is carried out. This sequence may be repeated as long as desired, and in this case three such implanted layers are created before a final layer is epitaxially grown thereupon to the end result shown in Fig. 3F. In this way it has been possible to obtain a thick buried second layer by adding the three implanted layers to each other thanks to a co-ordination of the regrowth of layers with the conditions of the implantation step following thereupon for making the layer obtained by the implantation step extending through the entire layer previously regrown. In fig 3A-F it has on the left hand been illustrated how the method may be carried out for obtaining a vertical shape of the thick layer. Another advantage of this method is that bevelled forms may be created and this has been illustrated on the right part of each figure.

The different lateral extensions of the implanted layers in Fig. 2 as well as in Fig. 3A-F have been achieved by using conventional semiconductor processing techniques, such as masking.

Fig. 4 shows a high voltage J-FET as an example of a device structure using buried grids and obtainable by the inventional method. This semiconductor device has a lower drain 5, a highly doped n-type substrate layer 6 for forming a good contact to the drain, a low-doped n-type drift region layer 7, in which highly doped p-type gate layers 8 are buried and an additional highly doped n-type layer for forming a contact layer to a source 10. The width of conducting channels 11 between adjacent gate layers 8 may be varied by varying a voltage applied on said gates, so that a current through the device may be controlled in that way and totally cut off by turning the channel regions into p-type layers. The buried layers 8 have been formed by an implantation step, and after that the rest of the layer 7 has been grown on top thereof, and then the introduction of dopants has been raised for obtaining the highly doped layer 9 on top thereof. Thus, a pn-junction could in this way be formed deep in a semiconductor device in desired positions while obtaining an optimum crystalline quality of the layers on top thereof.

The invention is of course not in any way restricted to the preferred embodiments described above, but many possibilities and modifications thereof would be apparent to a man with ordinary skill in the art.

The conductivity types of the dopants mentioned above may of course be exchanged, so that for instance n-type dopants are implanted in a p-type first layer, and it could under certain circumstances also be desired to implant dopants of the same conductivity type as of the layer into which it is implanted, and this alternative is also intended to lie within the scope of the invention.

Furthermore, it is not necessary that a semiconductor device produced by using the method according to the invention has SiC as the only semiconductor material, but only said first, second and third layers have to be of SiC and the device may have hetero-character should this be desired.

All definitions concerning the material of the different layers of course also include inevitable impurities as well as intentional doping when SiC is concerned. "A semiconductor layer of SiC" is also to be interpreted as covering the case in which small amounts of other elements are added to that layer, for instance smaller amounts of group 3B-elements.

A numerous of further conventional process steps, such as passivation, well known to those skilled in the art may be combined with the steps according to the inventional method for production of semiconductor devices therethrough.

It has been illustrated above how said first semiconductor layer is epitaxially grown in step a), but it is within the scope of the invention to use a substrate for this first layer, so that the growth in step a) is then accomplished by using the sublimation technique.

## Claims

1. A method of producing a semiconductor device having semiconductor layers of SiC with at least three doped layers on top of each other, comprising a step a) of growing a first semiconductor layer (1) of SiC, a step b) following upon step a) of implanting an impurity dopant into said first layer for forming a second doped surface layer (3) as a sub-layer within said first layer, comprising a step c) following upon step b) and in which a third semiconductor layer (4) of SiC is epitaxially grown on top of said second layer (3) of SiC, wherein said growth in said step c) is carried out at such a high temperature that the dopants implanted in step b) are made electrically active and implantation damages are reduced, and wherein the implantation in step b) is carried out for producing a second doped surface layer (3), which is surnounded, except for the top surface thereof, by said first semiconductor layer (1), and wherein in step c) said third semiconductor layer (4) is epitaxially grown on top of said second layer (3) as well as on top of regions of said first layers (1) next thereto an thereby surrounding and totally burying said second semiconductor layer.

2. A method according to claim 1, **characterized in that** said temperature is higher than 1 500°C.

3. A method according to any of claims 1 to 2, **characterized in that** in step c) said third semiconductor layer (4) is grown by Chemical vapour Deposition (CVD).

4. A method according to any of claims 1-3, **characterized in that** in step b) an impurity dopant of a first conductivity type, one of a) n and b) p, is implanted in said first semiconductor layer (1) being doped according to a second opposite conductivity type for forming a pn-junction at the interface between said first and second layers.

5. A method according to any of claims 1-4, **characterized in that** said impurity dopants implanted in step b) are of p-type.

6. A method according to claim 5, **characterized in that** boron is implanted as impurity dopant in step b).

7. A method according to claim 5, **characterized in that** aluminium is implanted as impurity dopant in step b).

8. A method according to claim 6, **characterized in that** the implantation in step b) is carried out while keeping the first semiconductor layer (1) of SiC at a temperature of 400-600°C.

9. A method according to any of claims 1-8, **characterized in that** adjacent layers of said three layers (1, 3, 4) are doped according to different conductivity types, one of a) n and b) p.

10. A method according to claim 9, **characterized in that** in step c) said third semiconductor layer (4) is grown with a lower doping concentration than the doping concentration of the second semiconductor layer (3) obtained by said implantation.

11. A method according to any of claims 1-10, **characterized in that** said first and third layers are epitaxially grown in step a) and step c) while doping them with n-type dopants.

12. A method according to claim 11, **characterized in that** said third semiconductor layer (4) is in step c) grown while giving it a low doping concentration.

13. A method according to any of claims 1-12, **characterized in that** it comprises several alternating successive steps of implantation and regrowth according to the steps b) and c).

14. A method according to claim 13, **characterized in that** the regrowth of layers is co-ordinated with the conditions of the implantation step following thereupon for making the layer obtained by that implantation step extending through the entire layer previously regrown and connecting to the layer previously obtained by the previous implantation step for forming a continuous thick implanted layer.

15. A method according to claims 1 and 14, **characterized in that** a regrowth step is carried out after the last implantation step for forming said thick continuous implanted layer for forming a semiconductor device having a thick buried layer.

## Patentansprüche

1. Verfahren zum Herstellen einer Halbleitervorrichtung, die Halbleiterschichten aus SiC mit mindestens drei dotierten Schichten übereinander aufweist, mit einem Schritt a), dass eine erste Halbleiterschicht (1) aus SiC aufgewachsen wird, einem Schritt b) in Anschluss an Schritt a), dass ein Fremdstoffdotiermittel in die erste Schicht implantiert wird, um eine zweite dotierte Oberflächenschicht (3) als eine Teilschicht innerhalb der ersten Schicht zu bilden, mit einem Schritt c) in Anschluss an Schritt b), in dem eine dritte Halbleiterschicht (4) aus SiC epitaktisch oben auf die zweite Schicht (3) aus SiC aufgewachsen wird, wobei das Aufwachsen in Schritt c) auf einer solch hohen Temperatur ausgeführt wird, dass die in Schritt b) implantierten Dotiermittel elektrisch aktiv gemacht und Implantationsschäden verringert werden, und wobei die Implantation in Schritt b) ausgeführt wird, um eine zweite dotierte Oberflächenschicht (3) herzustellen, die mit Ausnahme ihrer oberen Oberfläche von der ersten Halbleiterschicht (1) umgeben ist, und wobei in Schritt c) die dritte Halbleiterschicht (4) epitaktisch oben auf die zweite Schicht (3) sowie oben auf Bereiche der ersten Schicht (1) benachbart dazu aufgewachsen wird und **dadurch** die zweite Halbleiterschicht umgibt und vollständig vergräbt.

2. Verfahren nach Anspruch 1, **dadurch gekennzeichnet, dass** die Temperatur höher als 1500°C ist.

3. Verfahren nach einem der Ansprüche 1 oder 2, **dadurch gekennzeichnet, dass** in Schritt c) die dritte Halbleiterschicht (4) durch Abscheidung aus der Dampfphase (CVD) aufgewachsen wird.

4. Verfahren nach einem der Ansprüche 1 bis 3, **dadurch gekennzeichnet, dass** in Schritt b) ein Fremdstoffdotiermittel mit einem ersten Leitfähigkeitstyp, und zwar einer von a) n und b) p, in die erste, gemäß einem zweiten entgegengesetzten Leitfähigkeitstyp dotierte Halbleiterschicht (1) implantiert wird, um einen pn-Übergang an der Grenzfläche zwischen der ersten und zweiten Schicht zu bilden.

5. Verfahren nach einem der Ansprüche 1 bis 4, **dadurch gekennzeichnet, dass** die in Schritt b) implantierten Fremdstoffdotiermittel vom p-Typ sind.

6. Verfahren nach Anspruch 5, **dadurch gekennzeichnet, dass** in Schritt b) Bor als das Fremdstoffdotiermittel implantiert wird.

7. Verfahren nach Anspruch 5, **dadurch gekennzeichnet, dass** in Schritt b) Aluminium als Fremdstoffdotiermittel implantiert wird.

8. Verfahren nach Anspruch 6, **dadurch gekennzeichnet, dass** die Implantation in Schritt b) ausgeführt wird, während die erste Halbleiterschicht (1) aus SiC auf einer Temperatur von 400-600°C gehalten wird.

9. Verfahren nach einem der Ansprüche 1 bis 8, **dadurch gekennzeichnet, dass** benachbarte Schichten der drei Schichten (1, 3, 4) gemäß unterschiedlichen Leitfähigkeitstypen dotiert werden, und zwar einer von a) n und b) p.

10. Verfahren nach Anspruch 9, **dadurch gekennzeichnet, dass** in Schritt c) die dritte Halbleiterschicht (4) mit einer niedrigeren Dotierungskonzentration als die durch die Implantation erhaltene Dotierungskonzentration der zweiten Halbleiterschicht (3) aufgewachsen wird.

11. Verfahren nach einem der Ansprüche 1 bis 10, **dadurch gekennzeichnet, dass** die erste und dritte Schicht in Schritt a) und Schritt c) epitaktisch aufgewachsen werden, während sie mit Dotiermitteln vom n-Typ dotiert werden.

12. Verfahren nach Anspruch 11, **dadurch gekennzeichnet, dass** die dritte Halbleiterschicht (4) in Schritt c) aufgewachsen wird, während ihr eine niedrige Dotierungskonzentration verliehen wird.

13. Verfahren nach einem der Ansprüche 1 bis 12, **dadurch gekennzeichnet, dass** es mehrere abwechselnde, aufeinander folgende Schritte von Implantation und erneutem Aufwachsen nach den Schritten b) und c) umfasst.

14. Verfahren nach Anspruch 13, **dadurch gekennzeichnet, dass** das erneute Aufwachsen von Schichten mit den Bedingungen des darauf folgenden Implantationsschrittes abgestimmt wird, um die durch diesen Implantationsschritt erhaltene Schicht derart einzurichten, dass sie sich durch die gesamte zuvor aufgewachsene Schicht erstreckt und sich mit der zuvor durch den vorhergehenden Implantationsschritt erhaltenen Schicht verbindet, um eine kontinuierliche dicke implantierte Schicht zu bilden.

15. Verfahren nach den Ansprüchen 1 und 14, **dadurch gekennzeichnet, dass** ein Schritt eines erneuten Aufwachsens nach dem letzten Implantationsschritt zum Bilden der dicken kontinuierlichen implantierten Schicht ausgeführt wird, um eine Halbleitervorrichtung mit einer dicken vergrabenen Schicht zu bilden.

## Revendications

1. Méthode de production d'un dispositif semi-conducteur ayant des couches semi-conductrices de SiC avec au moins trois couches dopées les unes sur les autres, comprenant une étape a) de croissance d'une première couche semi-conductrice (1) de SiC, une étape b) suivant immédiatement l'étape a) d'implantation d'un dopant d'impureté dans ladite première couche afin de former une deuxième couche (3) de surface dopée en tant que sous-couche à l'intérieur de ladite première couche comprenant une étape c) suivant immédiatement l'étape b) et au cours de laquelle une troisième couche semi-conductrice (4) de SiC est formée par croissance épitaxiale en croissance sur ladite seconde couche (3) de SiC, dans laquelle ladite croissance de l'étape c) est réalisée à une température élevée telle que les dopants implantés à l'étape b) soient rendus électriquement actifs et que les imperfections d'implantation soient réduites, et dans laquelle l'implantation de l'étape b) est réalisée afin de produire une deuxième couche (3) de surface dopée, qui est surmontée, à l'exception de sa surface supérieure, par ladite première couche semi-conductrice (1), et où dans l'étape c) ladite troisième couche semi-conductrice (4) est déposée par croissance épitaxiale au-dessus de ladite deuxième couche (3) ainsi bien au-dessus des régions de ladite première couche (1) qui lui sont voisines et ainsi pour entourer et englober entièrement ladite deuxième couche semi-conductrice.

2. Méthode selon la revendication 1, **caractérisée en ce que** ladite température est supérieure à 1 500°C.

3. Méthode selon l'une quelconque des revendications 1 ou 2, **caractérisée en ce qu'**au cours de l'étape c) ladite troisième couche semi-conductrice (4) est déposée par dépôt chimique en phase vapeur (CVD).

4. Méthode selon l'une quelconque des revendications 1 à 3, **caractérisée en ce qu'**au cours de l'étape b) un dopant d'impureté d'un premier type de conductivité, un a) de n et b) de p, est implanté dans ladite première couche semi-conductrice (1) qui est dopée selon un second type de conductivité opposée afin de former une jonction pn au niveau de l'interface entre lesdites première et deuxième couches.

5. Méthode selon l'une quelconque des revendications 1 à 4, **caractérisée en ce que** lesdits dopants d'impureté implantés à l'étape b) sont du type p.

6. Méthode selon la revendication 5, **caractérisée en ce que** du bore est implanté comme dopant d'impureté à l'étape b).

7. Méthode selon la revendication 5, **caractérisée en ce que** de l'aluminium est implanté comme dopant d'impureté à l'étape b).

8. Méthode selon la revendication 6, **caractérisée en ce que** l'implantation de l'étape b) est réalisée tout en maintenant la première couche semi-conductrice (1) de SiC à une température de 400-600°C.

9. Méthode selon l'une quelconque des revendications 1 à 8, **caractérisée en ce que** les couches adjacentes desdites trois couches (1,3,4) dont dopées selon différents types de conductivité, une a) de n et b) de p.

10. Méthode selon la revendication 9, **caractérisée en ce que** dans l'étape c) ladite troisième couche semi-conductrice (4) est développée en croissance avec une concentration de dopant inférieure à la concentration de dopant de la deuxième couche semi-conductrice (3) obtenue par ladite implantation.

11. Méthode selon l'une quelconque des revendications 1 à 10, **caractérisée en ce que** lesdites première et troisième couches sont déposées par croissance épitaxiale aux étapes a) et c) en les dopant avec des dopants de type n.

12. Méthode selon la revendication 11, **caractérisée en ce que** ladite troisième couche semi-conductrice (4) est développée en croissance pendant l'étape c) tout en lui donnant une faible concentration en dopant.

13. Méthode selon l'une quelconque des revendications 1 à 12, **caractérisée en ce qu'**elle comprend différentes étapes alternant successives d'implantation et de re-développement en croissance selon les étapes b) et c).

14. Méthode selon la revendication 13, **caractérisée en ce que** le re-développement des couches est coordonné avec les conditions de l'étape d'implantation lui succédant pour faire en sorte que la couche obtenue par cette étape d'implantation s'étende à travers la couche entière précédemment re-développée et se connecte à la couche précédemment obtenue par l'étape d'implantation précédente afin de former une couche implantée épaisse continue.

15. Méthode selon les revendications 1 à 14, **caractérisée en ce qu'**une étape de re-déposition est réalisée après la dernière étape d'implantation afin de former ladite couche implantée épaisse continue pour former un dispositif semi-conducteur ayant une couche enrobée épaisse.
